# EUROPÄISCHE PATENTSCHRIFT

(11) **EP 2 612 156 B1**
(45) Veröffentlichungstag und Bekanntmachung des Hinweises auf die Patenterteilung: **28.04.2021**
(21) Anmeldenummer: 11763868.4
(22) Anmeldetag: 02.09.2011
(51) Int. Cl.: G01R 31/319, G01R 31/28, G01R 1/04, G01R 31/26

(54) **MODULARER PROBER UND VERFAHREN ZU DESSEN BETRIEB**
MODULAR SCANNER, AND METHOD FOR OPERATING SAME
ÉCHANTILLONNEUR MODULAIRE ET SON PROCÉDÉ DE FONCTIONNEMENT

(30) Priorität: 03.09.2010 DE 102010040242
(43) Veröffentlichungstag der Anmeldung: 10.07.2013
(73) Patentinhaber: Cascade Microtech, Inc., Beaverton, OR 97008 (US)
(72) Erfinder: KANEV, Stojan, 01561 Thiendorf OT Sacka (DE); HIRSCHFELD, Botho, 01108 Dresden (DE); BECKER, Axel, 01157 Dresden (DE); HACKIUS, Ulf, 01279 Dresden (DE)
(74) Vertreter: Lippert Stachow Patentanwälte Rechtsanwälte Partnerschaft mbB
(86) Internationale Anmeldenummer: PCT/EP2011/065169
(87) Internationale Veröffentlichungsnummer: WO 2012/028705

(56) Entgegenhaltungen:
- EP-A2- 1 049 153
- WO-A1-99/49500
- DE-A1- 10 246 232
- DE-U1- 20 319 625
- US-A- 6 111 421
- US-A1- 2003 028 343
- US-B1- 6 420 864
- Cae: "APPLIED MATERIALS / ORBOT WF-736", , 16. August 2011 (2011-08-16), XP55012963, Gefunden im Internet: URL:http://www.caeonline.com/listing/produ ct/67525/applied-materials-orbot-wf-736 [gefunden am 2011-11-23]

## Beschreibung

Die Erfindung betrifft allgemein eine Prüfstation zum Prüfen und Testen von elektronischen Halbleiterbauelementen, allgemein als Prober bezeichnet. Sie betrifft insbesondere einen solchen Prober, in dem zumindest zwei Probenaufnahmen von einem gemeinsamen Handlingsystem mit den zu testenden Halbleiterbauelementen versorgt werden und zumindest einige der mit dem Prüfungsverfahren verbundenen Schritte automatisiert ausgeführt werden können.

Die Erfindung betrifft ebenso ein Verfahren zur Durchführung eines zumindest teilweise automatisierten Prüfungsverfahrens mittels eines solchen Probers.

Zur Messung elektronischer Bauelemente beispielsweise zu Zwecken der Funktions- oder Alterungsprüfung werden Kontaktinseln auf der Vorderseite der Bauelemente mittels Kontaktspitzen kontaktiert und elektrisch mit Testeinrichtungen verbunden, mittels derer die Eigenschaften der einzelnen Bauelemente gemessen werden. Über die Kontaktspitzen werden die entsprechenden Signale eingespeist und/oder abgegriffen.

In Probern werden auf diese Weise die unterschiedlichsten elektronischen Halbleiterbauelemente, hinsichtlich ihrer elektrischen Eigenschaften geprüft oder speziellen Test unterzogen. Dabei können die Bauelemente in verschiedenen Fertigungs- und Integrationsstufen vorliegen. So werden Tests von Halbleiterchips, Hybridbauelementen, mikromechanische sowie mikrooptischen Bauelementen und dergleichen durchgeführt, die sich noch im Waferverbund befinden oder vereinzelt oder bereits in mehr oder weniger komplexen Schaltungen integriert sind. Mitunter, z.B. während der Entwicklung, liegen auch lediglich einzelne Bruchstücke mit unregelmäßigen Formen und Abmessungen vor, die aufgrund dessen, aber auch aufgrund besonderer, mit der Entwicklung verknüpfter Prüfaufgaben vollständig manuell geprüft werden müssen. Verallgemeinernd werden die zu testenden elektronischen Halbleiterbauelemente auch als Testsubstrate bezeichnet.

Allgemein ist es für die Entwicklung und Herstellung der Testsubstrate erforderlich, in den verschiedenen Fertigungsstufen unterschiedlichste Tests und Prüfungen vorzunehmen. Bekanntermaßen werden dazu Prober verwendet, die im Wesentlichen einen Chuck mit einer Oberfläche zur Aufnahme von Testsubstraten umfassen. Der Chuck ist meist in X- und Y-Richtung verfahrbar. Der Prober weist weiterhin eine Sondenhalterung mit den Sonden, auch Probes genannt, zur elektrischen Kontaktierung der Testsubstrate auf. Zur Herstellung des elektrischen Kontaktes ist neben der Verfahrbarkeit in der X-Y-Ebene, die stets als die Ebene definiert ist, in welcher die Aufnahmefläche des Chucks liegt, eine Relativbewegung in Z-Richtung zwischen den Sonden und den Testsubstraten erforderlich. Die erforderlichen Bewegungen in Z-Richtung sind meist durch den Chuck im Zusammenhang mit einer Positionierungseinrichtung der Sondenhalterung realisierbar.

Es sind die verschiedensten Positionierungseinrichtungen zur Bewegung des Chucks und/oder der Sonden und/oder der Sondenhalterung und daraus folgende unterschiedliche Bewegungsabläufe bekannt, mit denen die zur Positionierung der Sonden und/oder der Testsubstrate und die zur Kontaktierung durch die Sonden erforderlichen Relativbewegungen ausgeführt werden. Mit zunehmender Integrationsdichte und damit verbundener Minimierung der Größe der Kontaktflächen werden die Anforderungen an die Genauigkeit der Positionierung von Sonden und Testsubstrat immer größer, insbesondere wenn die Einzelpositionen einer Vielzahl von Testsubstraten, die im Waferverbund oder vereinzelt rasterartig auf dem Chuck angeordnet sind, nacheinander anzufahren sind. Dazu werden der Wafer oder die einzelnen Testsubstrate so auf dem Chuck angeordnet, dass deren Raster sehr genau mit der X- und der Y-Bewegungsrichtung des Chucks bzw. der Sonden übereinstimmt, d.h. das Raster und die entsprechenden Bewegungsrichtungen der Positionierungseinrichtungen sind in-line. Das Anfahren der Einzelpositionen der Testsubstrate kann dann durch schrittweises Abfahren des Rasters in X- oder in Y-Richtung auch automatisiert erfolgen.

Zur vollautomatischen und damit bedienerfreien Prüfung und zur Erzielung eines hohen Durchsatzes bei der Prüfung wird auch Auflegen und das Wechseln der Testsubstrate auf dem Chuck automatisiert durchgeführt, mit einem entsprechend ausgestatteten Handlingsystem. Dieses legt ein Testsubstrat auf dem Chuck ab und entnimmt es nach dem Testvorgang wieder. Auch eine Entnahme und Ablage der Testsubstrate aus bzw. in Magazinen kann durch ein Handlingsystem erfolgen. Um eine präzise Ablage zu ermöglichen, was den nachfolgenden Positionierungsaufwand relativ zu den Sonden deutlich reduziert, kann auch eine Ausrichtstation angeordnet sein, die ein Testsubstrat vor der Ablage auf dem Chuck in Bezug auf eine Referenz ausrichtet, durch das Handlingsystem versorgt werden.

So wird in der DE 10 2004 041 102 A1 ein Prober beschrieben, bei dem zum Ausgleich größere Zeitdifferenzen zwischen dem Test und der Positionierung ein Puffermodul integriert ist, in welchem vor- oder nachbereitende Behandlungen wie eine Temperierung der Prüfung durchgeführt werden, und dieses Modul gemeinsam mit zumindest einem weiteren Testmodul und zwei Substratmagazinen durch ein Handlingsystem bedient werden. Dieser Prober ist für Einzelmessungen z.B. als Laborprober in der Entwicklung als auch als vollautomatischer Prober anwendbar.

Ein vollautomatischer Prober beinhaltet neben der eigentlichen Testanordnung, die im Wesentlichen wie oben beschrieben aus Chuck mit motorisiertem Antrieb, Einzelsonden oder Sondenkarte, einer Steuerelektronik, und entsprechenden Aufnahme- und Verbindungsmitteln besteht, ein Mustererkennungssystem zur Scheibenselbstjustage, CCD-Kamera oder Mikroskop zur Beobachtung des Testsubstrates, Monitor, Handlingsystem, Scheibenmagazinstation und Ausrichtstation.

Auch aus der Herstellung von elektronischen Halbleiterbauelementen sind vollautomaische Prober als Bestandteil einer Waferbearbeitungsanlage bekannt. Dabei ist ein Handlingsystem zentral zu Behandlungs- und Prüfkammern angeordnet und führt nach der Eingabe mehrerer Testsubstrate in die Anlage, meist mittels Kassetten oder Magazinen, das Handling zwischen den einzelnen Stationen eines Durchlaufs vollautomatisch aus (US 6,420,864 B1). Hier kann über geeignete Schnittstellen mit Anzeige- und Kommunikationsmitteln auch eine Überwachung oder ein Eingriff eines Operators in den Prozess mittels einer Steuereinheit erfolgen.

WO 99/49500 betrifft ein Cluster-Werkzeug zum Testen von Substraten und zum Auffinden von Störstellen auf dem Substrat, die zuerst in einem Prüfwerkzeug ermittelt und in einem nachrangigen Revisionswerkzeug erneut überprüft werden. Dazu ist die Werkzeuge über eine Automatisierungsplattform miteinander verbunden, so dass mit der Automatisierungsplattform die Substrate zwischen den Werkzeugen hin und her bewegt werden können.

US 2003/0028343 A1 betrifft ein intelligentes modulares halbleiterparametrisches Mess- und Testsystem, welches ein Maschinensteuerungsmodul beinhaltet. Das Maschinensteuerungsmodul ist derart bedienbar, dass eine Kommunikation mit dem Nutzer über eine Schnittstelle möglich ist, und es ist im Weiteren derart bedienbar, dass eine Kommunikation mit einer Steuerung des Zustands eines anderen Moduls in dem halbleiterparametrischen Testsystem einschließlich anschließbarer Module möglich ist. Das Maschinensteuerungsmodul kann im Weiteren derart bedient werden, dass ein Testfluss gesteuert werden kann, wobei die Steuerung basierend auf Daten und Steuerereignisse, die von einem intelligenten Messmodul empfangen werden, erfolgt.

US 6,111,421 betrifft ein Prüfverfahren mittels Sonden, bei dem die elektrischen Eigenschaften eines Objektes dadurch inspiziert werden, dass die Elektroden des zu inspizierenden, sich auf einem Chuck befindenden Objektes mit den Sonden einer Sondenkarte in Verbindung gebracht werden. Der Chuck ist dazu in X-, Y-, Z- und θ-Richtung beweglich

DE 102 46 232 betrifft einen Prober mit Beladevorrichtung und mit einem Aufnahmemittel für die Aufnahme von Testsubstraten, das von einem Arbeitsbereich des Chucks zu einer Aufnahmeposition außerhalb des Arbeitsbereiches verfahrbar ist.

Nachteilig erweist es sich, dass bei solchen automatisierten Probern der gesamte Ablauf und insbesondere das Handling auf bestimmte Testsubstrate zugeschnitten und ein Wechsel der Substrate oder im Prüfablauf nicht oder nur mit unverhältnismäßig hohem Aufwand möglich ist.

Der Erfindung liegt somit die Aufgabe zugrunde, einen Prober nach Anspruch 1 zur automatisierten Prüfung von Testsubstraten zu beschreiben, bei dem auch einzelne, in Art und Form von den übrigen abweichende Testsubstrate geprüft und/oder spezielle, auf einzelne Testsubstrate zugeschnittene Prüfungen durchgeführt werden können Ein entsprechendes Verfahren zum Betrieb eines solchen Probers wird im Anspruch 7 beschrieben.

Es wird ein Prober beschrieben, der verschiedene Module aufweist, die mittels einer Schaltvorrichtung des Probers in verschiedener Weise miteinander kombiniert werden können, so dass sowohl ein vollautomaischer Betrieb als auch halbautomatischer Betrieb wahlweise durch Umschalten möglich ist.

Dazu sind die Module selbst so konfiguriert, dass deren Aufgaben sowohl manuell als auch automatisiert ausführbar sind und es sind Module ergänzt, die der zumindest teilweise manuellen oder der automatisierten Prüfung dienen. Auf diese Weise ist der beschriebene Prober für Einzelprüfungen ebenso verwendbar wie für vollautomatisierte Prüfungen.

Einzelprüfungen kommen dann in Betracht, wenn aufgrund eines besonderen Testsubtrats z.B. eines Wafer-Bruchstückes oder aufgrund einer hinsichtlich der Prüfbedingungen oder des Prüfablaufs gesonderten Prüfung keine Wiederholungsprüfungen möglich oder erforderlich sind.

Als Module sind insbesondere zwei separate Prüfeinrichtungen angeordnet, die jeder für sich mit einer eigenen Maschinensteuerung und einer eigenen Prozesssteuerung verbunden sind und in dieser Anordnung als eigene Prober im herkömmlichen Sinn fungieren können.

Zu diesem Zweck umfasst jede Prüfeinheit einen eigenen Chuck zur Aufnahme und Halterung eines Testsubstrats auf einer Aufnahmefläche des Chucks, eine eigene Sondenhalterung mit einer Anordnung von mehreren Sonden zur elektrischen Kontaktierung eines Testsubstrats und eine eigene Positionierungseinheit mit motorisierten Antrieben zur Positionierung von Chuck und Sondenanordnung relativ zueinander.

Gemeinsam mit der jeder Prüfeinheit zugeordneten Maschinensteuerung, die als Leistungssteuerung der Steuerung der motorisierten Antriebe der jeweiligen Prüfeinheit dient, sowie der außerdem jeder Prüfeinheit zugeordneten Prozesssteuerung zur Steuerung des Prüfprozesses der jeweiligen Prüfeinheit können mit jeder Prüfeinheit eigenständig verschiedene Prüfungen von Testsubstraten vorgenommen werden, wie es aus dem Stand der Technik hinlänglich bekannt ist.

Dies schließt auch ein, dass in einer Speichereinheit, die einer der beiden Maschinensteuerungen zugeordnet ist, Positionierungsabläufe und in einer Speichereinheit, die einer der beiden Prozesssteuerungen zugeordnet ist, Daten des Testsubstrats und von Prüfabläufen gespeichert sind. Die gespeicherten Daten über die Testsubstrate, wie z.B. so genannte Wafer-Maps über die Lage und Größe von Kontaktflächen einer gleichzeitig mit den Sonden zu kontaktierenden Komponente eines Testsubstrats und gegebenenfalls auch die Rasterabstände der sich wiederholenden Strukturen, sowie über Positionierungs- und Prüfabläufe gestatten die automatisierte Durchführung einzelner Schritte des Prüfverfahrens. Dies betrifft bei den oben genannten Speicherdaten z.B. das Anfahren der nächsten Wiederholstruktur eines Wafers mit rasterartig angeordneten gleichartigen Strukturen des Testsubstrats nach einer ersten Positionierung und Prüfung. Auch der Prüfablauf selbst hinsichtlich der einzuspeisenden und zu empfangenden Signale, einer ersten Verarbeitung der empfangenen Signale oder hinsichtlich einer besonderen Behandlung des Testsubstrats vor, nach oder während der Prüfung kann automatisch erfolgen.

Wie nachfolgend beschrieben wird, ist aufgrund der verschiedenen Kombination der Module des Probers die Datenspeicherung in nur einer Maschinen- oder Prozesssteuerung bereits ausreichend, wobei optional auch beide Maschinen- oder Prozesssteuerungen die genannten Datenspeicherungen aufweisen können.

Weiter umfasst der Prober Vorrichtungen zur Beladung der Prüfeinheiten mit Testsubstraten, und zwar sowohl eine Beladevorrichtung, die eine manuelle, d.h. durch einen Bediener ausgeführte Beladung des Chucks einer Prüfeinheit gestattet, als auch eine Ladeeinheit, die mit einem Handlingsystem ausgestattet ist zur automatisierten Übernahme und Übergabe eines Testsubstrats zwischen einem Testsubstratlager, z.B. einem Magazin und sowohl der einen als auch der anderen Prüfeinheit.

Die Anordnung von zwei oder mehr derart ausgestatteten Prüfeinheiten lässt neben der voll- oder halbautomatischen Prüfung auch eine Kombination beider Methoden in nur einem Prober zu.

Als vollautomatischer Betrieb soll in der vorliegenden Beschreibung ein solcher Betrieb zumindest einer der Prüfeinheiten des Probers verstanden sein, bei welchem die Beladung der Prüfeinheit mit einem Testsubstrat, dessen Positionierung relativ zur Sondenanordnung mittels der der Prüfeinheit zugehörigen Positionierungseinheit, die Herstellung des Kontakts zwischen Testsubstrat und den Sonden und die Durchführung aller für die Prüfung notwendigen Messungen nach einem gespeicherten Positionierungs- und Messregime vollständig automatisiert und ohne Eingriff eines Bedieners erfolgen.

Zum vollautomatischen Betrieb wird zumindest eine der Prüfeinheiten mit der Modulsteuerung des Probers verbunden, welche außerdem mit der Ladeeinheit des Probers verbunden ist. Entsprechend der Ausgestaltung der Modulsteuerung kann die Steuerung des Prüfprozesses in der verbundenen Prüfeinheit allein durch die Modulsteuerung erfolgen. In diesem Fall sind alle erforderlichen Prüfabläufe, die sonst in der Prozesssteuerung eines herkömmlichen Probers gespeichert sind, in einer Speichereinheit der Modulsteuerung hinterlegt und die Modulsteuerung kommuniziert direkt mit der Prüfeinheit und der Maschinensteuerung. Alternativ kann die Modulsteuerung auch auf Prozesssteuerung und die dort hinterlegt Prüfabläufe zugreifen und diese einschließlich der Maschinensteuerung lediglich koordinieren. Entsprechend dieser alternativen Ansteuerung der Prüfeinheit und sofern die Modulsteuerung keine eigene Benutzeroberfläche aufweist, kann eine Verbindung der Modulsteuerung mit einer Benutzeroberfläche des Probers mittels der Schaltvorrichtung erfolgen. In den verschiedenen Ausgestaltungen sind auch mehr als eine, gegebenenfalls auch alle Prüfeinheiten vollautomatisch betreibbar.

Demgegenüber soll als halbautomatischer Betrieb ein solcher Betrieb zumindest einer der Prüfeinheiten des Probers verstanden sein, bei welchem zumindest die Beladung des Chucks der Prüfeinheit, welche mit der Benutzeroberfläche verbundenen ist, manuell und damit für einzelne Testsubstrate erfolgt. Die manuelle Beladung kann aufgrund der hohen Anforderungen an die Präzision der Lage die Verwendung von Hilfsmitteln einschließen, die auch motorisierte Manipulatoren umfassen können. Auch können einzelne Schritte zur Positionierung des auf dem Chuck aufliegenden Testsubstrats relativ zur Sondenposition automatisiert erfolgen, d.h. entsprechend gespeicherter Positionierungsschritte, die z.B. nach dem präzisen Anfahren einer ersten oder Referenzposition anhand eines in der Maschinensteuerung gespeicherten Wafer-Maps als Nachfolgepositionen festgelegt werden können.

Infolge der manuell möglichen Beladung im Zusammenhang mit der Verbindung der betreffenden Prüfeinheit mit einer Benutzeroberfläche kann die Prüfeinheit separat wie ein herkömmlicher Prober verwendet werden.

Entsprechend einer Ausgestaltung des Betriebs des Probers können in der manuell betriebenen Prüfeinheit auch weitere Schritte des Prüfverfahrens manuell, d.h. unter aktueller Einflussnahme durch einen Bediener durchgeführt werden. So können die Positionierung des auf dem Chuck aufliegenden Testsubstrats und der Sonden relativ zueinander zumindest teilweise über solche Eingaben an der Benutzeroberfläche erfolgen, welche eine Bedienung der motorisierten Antriebe gestatten. Zu diesem Zweck kann die Benutzeroberfläche neben einer Anzeige- und einer Eingabevorrichtung zur Überwachung und Einflussnahme auf die Prüfung auch eine Manipulationsvorrichtung umfassen. Mithilfe der Manipulationsvorrichtung ist ein manuelles Anfahren definierter und/oder mittels einer Beobachtungsvorrichtung zu überwachender Positionen mit geregelten Antrieben möglich. Eine solche Manipulationsvorrichtung ist im einfachsten Fall ein Joystick. Aber auch eine Maus oder ein visueller Joystick, der mit der Eingabevorrichtung zu bedienen ist, oder andere Vorrichtungen sind möglich.

Die Erfindung soll nachfolgend anhand eines Ausführungsbeispieles näher erläutert werden. In der zugehörigen Zeichnung zeigt
- Fig. 1: eine schematische Darstellung eines Probers mit zwei Prüfeinheiten und einer Ladeeinheit und
- Fig. 2: eine schematische Darstellung einer Prüfeinheit.

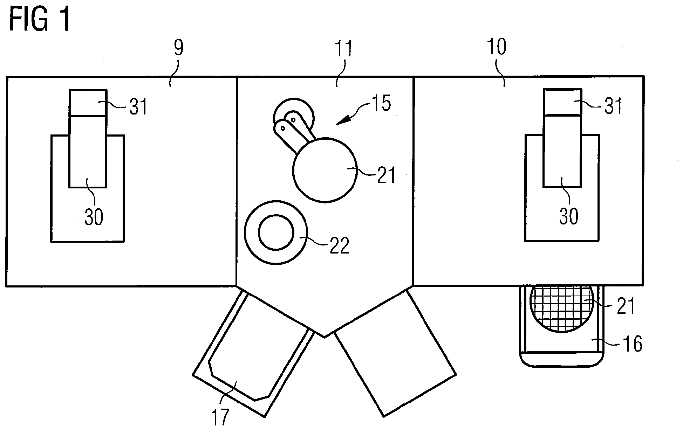

Der schematisch in Fig. 1 dargestellte Prober umfasst eine erste Prüfeinheit 9 und eine zweite Prüfeinheit 10, die in einer Reihe mit einer Ladeeinheit 11 angeordnet sind, so dass sich die Ladeeinheit 11 zwischen beiden Prüfeinheiten 9, 10 befindet und beide Prüfeinheiten 9, 10 mit Testsubstraten 21 versorgen kann.

Die zentrale Ladeeinheit 11 umfasst ein Handlingsystem 15, das in Fig. 1 nur schematisch dargestellt ist. Derartige Handlingsysteme sind allgemein bekannt. Ein für die Prüfung von elektronischen Halbleiterbauelementen üblicherweise verwendetes Handlingsystem 15 ist beispielsweise in der DE 10 2004 041 102 A1 beschrieben. Es umfasst regelmäßig einen oder mehr Roboterarme, die an einem Roboterantrieb angelenkt sind. An der freien Vorderseite des äußersten Roboterarmes ist eine Scheibenaufnahme angeordnet, durch die eine Unterseite eines Testsubstrats 21, im Ausführungsbeispiel eines Wafers aufgenommen und mittels Vakuum angesaugt und gehalten werden kann.

Weiterhin ist ein Wafer-Magazin 17 als Testsubstratlager an der Ladeeinheit 11 montiert, aus denen das Handlingsystem 15 Testsubstrate 21 entnimmt, an die erste Prüfeinheit 9 übergibt und nach der Prüfung von dort wieder übernimmt und im Wafer-Magazin 17 ablegt.

Zwischen dem Wafer-Magazin 17 und dem Handlingsystem 15 ist eine Ausrichtstation 22 angeordnet. Auf dieser wird ein dem Wafer-Magazin 17 entnommener Wafer 21 vor der Übergabe an die erste Prüfeinheit 9 abgelegt. In dieser Ausrichtstation 22 erfolgt eine Einstellung der Lage des Wafers 21, damit dieser für die Übergabe bereits eine richtige Lageorientierung aufweist und in der ersten Prüfeinheit 9 vor dem Prüfen nur noch fein justiert werden muss.

Wie oben beschrieben sind beide Prüfeinheiten 9, 10 sehr flexibel sowohl für die vollautomatische als auch für die halbautomatische Prüfung einsetzbar. Dementsprechend ist die Ladeeinheit 11 einschließlich Handlingsystem 15 und gegebenenfalls Ausrichtstation 22 konfiguriert und zentral angeordnet, so dass sie jede Prüfeinheit 9, 10 mit Testsubstraten 21 versorgen und auf ein oder mehrere Testsubstratlager zugreifen kann.

Üblicherweise dient die Ladeeinheit 11 dem automatischen Wechsel von Testsubstraten 21 für die Prüfeinheit 9, 10 und damit in erster Linie der vollautomatischen Prüfung. Gleichermaßen kann aber auch ein einzelnes Testsubstrat 21 über die Ladeeinheit 11 an eine Prüfeinheit 9 oder 10 übergeben werden, sofern es von seiner geometrischen Gestalt her durch das Handlingsystem handhabbar ist. Dies betrifft einzelne Wafer 21 ebenso wie z.B. unregelmäßig geformte Testsubstrate 21 oder bereits vereinzelte elektronische Bauelemente, die von geeigneten Trägersubstraten gehalten werden.

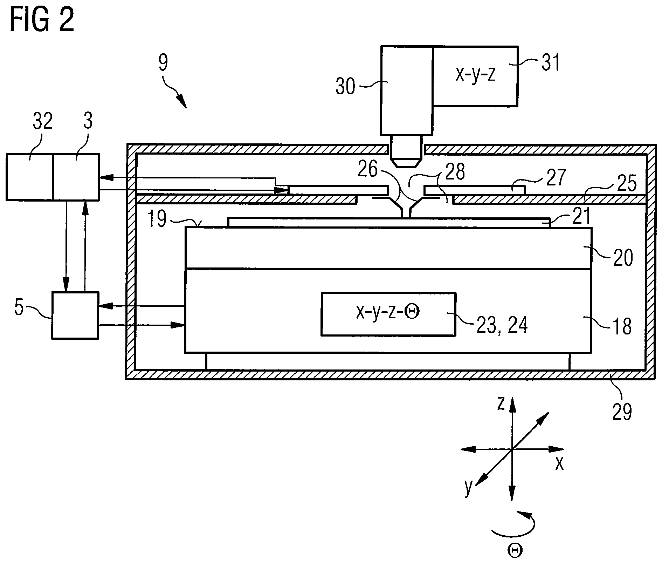

Die erste Prüfeinheit 9 ist wie auch die zweite Prüfeinheit 10 in der Draufsicht mit einem Gehäuse 29 im geschlossenen Zustand dargestellt, so dass die Komponenten der Prüfeinheiten 9, 10 in Fig. 1 nicht ersichtlich sind. Der wesentliche Aufbau der ersten Prüfeinheit 9 ist in Fig. 2 schematisch dargestellt und entspricht für sich betrachtet dem üblichen Aufbau einer separaten Prüfstation zur Prüfung von elektronischen Halbleiterbauelementen.

Wie in Fig. 2 ersichtlich umfasst eine erste Prüfeinheit 9 einen Chuck 18 mit einer Aufnahmefläche 19 zur Aufnahme von Testsubstraten 21 umfassen. Die Aufnahmefläche 19 ist im dargestellten Ausführungsbeispiel die obere Fläche einer Auflageplatte 20, die dem Chuck 18 entnehmbar ist.

Die erste Prüfeinheit 9 umfasst weiter eine Sondenhalterung 25, die der Aufnahmefläche 19 gegenüberliegend angeordnet ist. Die Sondenhalterung 25 hält eine Mehrzahl von Sonden 26 die zueinander derart angeordnet sind, dass sie mit der Anordnung der gleichzeitig zu kontaktierenden Kontaktflächen (nicht näher dargestellt) des Testsubstrats 21 korrespondieren. Die Sonden 26 in ihrer definierten Lage zueinander werden allgemein als Sondenanordnung 26 bezeichnet. Im dargestellten Ausführungsbeispiel ist die Sondenanordnung 26 an einer so genannten Probecard 27 fest montiert.

Eine Probecard 27 ist üblicherweise eine Leiterplatte, auf der die nadelförmigen Sonden 26 präzise ausgerichtet und fixiert sind und auf der auch die Zuleitungen zu den einzelnen Sonden 26 als Leiterbahnen ausgebildet sind. Alternativ können auch separate Sonden 26 auf der Sondenhalterung 25 montiert sein. Häufig sind separate Sonden 26 auch mittels geeigneter Manipulatoren (nicht dargestellt) direkt auf der Sondenhalterung 25 zueinander ausrichtbar. Derartige separate Sonden 26 werden meist für Einzelmessungen verwendet, für die die Herstellung einer Probecard 27 zu aufwändig ist.

Um das Testsubstrat 21 und die Sondenanordnung 26 relativ zueinander zu positionieren umfasst die erste Prüfeinheit 9 weiter eine Positionierungseinheit 23. Diese kann sehr unterschiedlich aufgebaut sein, in Abhängigkeit davon, welche Komponenten bewegt werden sollen. Üblicherweise umfasst eine Positionierungseinheit 23 einen Antrieb 24 für den Chuck 18, so dass dieser in X-, Y- und meist auch Z-Richtung verfahrbar ist. Für eine Winkelausrichtung ist der Chuck 18 regelmäßig um einen Winkel Θ drehbar. Die Lage von X-, Y-, und Z-Richtung sowie dem Winkel Θ ist dem Piktogramm in Fig. 2 zu entnehmen und entspricht der üblichen Ausrichtung. Der Antrieb 24 des Chucks 18 kann handbetrieben oder motorisiert sein. Für automatisierte Bewegungsabläufe ist ein motorisierter Antrieb 24 angeordnet, der durch eine Maschinensteuerung, in Fig. 2 der ersten Maschinensteuerung 5 gesteuert wird.

Zur Herstellung des elektrischen Kontakts der Sondenanordnung 26 auf dem Testsubstrat 21 ist neben der Verfahrbarkeit des Testsubstrats 21 in der X-Y-Ebene, die meist als die Ebene definiert ist, in welcher die Aufnahmefläche 19 des Chucks 18 liegt, eine Relativbewegung in Z-Richtung zwischen der Sondenanordnung 26 und dem Testsubstrat 21 erforderlich. Die erforderlichen Bewegungen in Z-Richtung werden im Ausführungsbeispiel mit einer Probecard 27 allein durch den Chuck 18 ausgeführt. Alternativ ist auch eine Kombination der Chuckbewegung mit einer Bewegung der Sondenanordnung 26 in Z-Richtung für die finale Sondenzustellung möglich. In diesem Fall weisen auch die Sonden Manipulatoren (nicht dargestellt), manuell oder motorisiert, auf. Alle genannten Komponenten für die Bewegung von Testsubstrat 21 und Sonden 26 relativ zueinander zum Zweck der Positionierung und Kontaktierung werden der Positionierungseinheit 23 zugeordnet.

Zur Beobachtung der Positionierung und Kontaktierung weist die erste Prüfeinheit 9 eine Beobachtungseinheit 30 auf, die mittels einer eigenen Steuerung 31 in X-, Y- und Z-Richtung verfahrbar ist, um den gesamten Kontaktierungsbereich in der erforderlichen Auflösung sichtbar zu machen. Die Beobachtung erfolgt durch korrespondierende zentrale Öffnungen 28 in der Sondenhalterung 25 und in der Probecard 27 sowie auch im Gehäuse 29, das die beschriebenen Komponenten umgibt.

Zur Steuerung des mit der ersten Prüfeinheit 9 auszuführenden Prüfablaufs umfasst diese außerdem eine erste Prozesssteuerung 3. Diese steuert alle Abläufe die Sondenanordnung 26, auch die Signalübertragung, sowie die Bewegung des Chucks 18 betreffend. Letzteres erfolgt über die erste Maschinensteuerung 5, welche die Steuersignale in Leistungssignale wandelt. Dementsprechend ist die Prozesssteuerung sowohl mit der Sondenanordnung 26 als auch mit der ersten Maschinensteuerung 5 verbunden. Alternativ kann die Maschinensteuerung 5 auch Teil der Prozesssteuerung 3 sein. In einer Speichereinheit 32 der ersten Prozesssteuerung 3 sind alle für Prüfabläufe benötigten Daten abrufbar gespeichert, insbesondere Daten des Testsubstrats, Daten zur Signalsteuerung der Prüfsignale und Daten zur Positionierung und Kontaktierung.

Der Prober gemäß Fig. 1 weist zwei der zu Fig. 2 beschriebenen Prüfeinheiten 9, 10 auf. Sie stimmen in Ihrem Grundaufbau überein. Die zweite Prüfeinheit 10 ist lediglich durch eine Beladevorrichtung 16 ergänzt. Diese dient der manuellen Beladung des Chucks 18 mit einem Testsubstrat 21 durch einen Bediener, indem die Beladevorrichtung 16 durch eine verschließbare Öffnung (nicht näher dargestellt) in der Vorderseite des Gehäuses 29 der zweiten Prüfeinheit zwischen einer Beladeposition außerhalb des Gehäuses und einer chucknahen Position innerhalb verfahrbar ist und Mittel (nicht näher dargestellt) zur Aufnahme und Übergabe Auflageplatte 20 des Chucks aufweist, so dass mit dieser die Testsubstrate 21 austauschbar sind. Derartige Beladevorrichtungen sind aus dem Stand der Technik hinreichend bekannt, z.B. aus der DE 102 46 232 A1. Mithilfe der Beladevorrichtung 16 sind Testsubstrate 21 unabhängig von der Ladeeinheit 11 in den Prober zu bringen.

Im dargestellten Ausführungsbeispiel weist lediglich die zweite Prüfeinheit 10 eine Beladevorrichtung 16 auf. Für eine höhere Flexibilität des Probers kann auch die erste Prüfeinheit 9 mit einer Beladevorrichtung ausgestattet sein.

Zur Prüfung wird die Sondenanordnung 26 gleichzeitig auf den Kontaktflächen eines Testsubstrats 21 aufgesetzt und das Testsubstrat 21 mit einem Signal beaufschlagt oder ein Signal vom Testsubstrat 21 abgegriffen. Dann wird der Kontakt gelöst und das nächste Testsubstrat 21 oder die in X- oder in Y-Richtung nächsten Anordnung von Kontaktflächen desselben Testsubstrats 21 angefahren und dieses zur Prüfung kontaktiert. Die Prüfung kann dabei unter den besonderen Prüfbedingungen erfolgen, die innerhalb des Gehäuses eingestellt werden, wie z.B. Prüfungen unter besonderen Umgebungs- und Temperaturbedingungen, Low-Current- und Low-Voltage-Messungen und andere Prüfungen. Je nach Anwendungsfall und Ausstattungen der Prüfeinheiten 9, 10 können in beiden gleiche oder voneinander abweichende Prüfungen des Testsubstrats 21 durchgeführt werden.

Die zuvor beschriebenen Komponenten des Probers wirken wie folgt zusammen.

Danach sind die erste und die zweite Prüfeinheit 9, 10 direkt mit der ersten bzw. der zweiten Maschinensteuerung 5 verbunden und über diese mit der ersten bzw. der zweiten Prozesssteuerung 3. Beide Prozesssteuerungen umfassen eine eigene Speichereinheit 32. Üblicherweise sind die Steuerungen in jeder Prüfeinheit integriert. Die Prozesssteuerungen sind mit einer Modulsteuerung und parallel dazu mit der Ladeeinheit 11 verbunden.

Darüber hinaus sind die Prozesssteuerungen sowie die Modulsteuerung und darüber hinaus eine erste Benutzeroberfläche und eine zweite Benutzeroberfläche jeweils mit einer zentralen Schaltvorrichtung verbunden. Beide Benutzeroberflächen umfassen eine Anzeigevorrichtung (Display) und eine Eingabevorrichtung (Tastatur). Die Benutzeroberflächen gemäß Ausführungsbeispiel weisen darüber hinaus als Manipulationsvorrichtung je einen Joystick auf, mit welchem die motorisierten Antriebe 24 gegebenenfalls mithilfe der Beobachtungseinheit 30 bedienbar sind. Da bekanntermaßen die Funktionen von Manipulationsvorrichtungen häufig durch eine Tastatur auszuführen sind, kann die Manipulationsvorrichtung auch entfallen.

Entsprechend der Komponenten der Benutzeroberfläche wird als Schaltvorrichtung im Ausführungsbeispiel ein sogenannter KVM-Switch (Keybord-Video-Mouse-Switch) verwendet, der es ermöglicht, mehrere Steuerungen mit nur einer solchen Benutzeroberfläche zu steuern. Alternativ sind auch andere Schaltvorrichtungen einsetzbar, sofern sie in der Lage sind, die mit der Schaltvorrichtung verbundenen Endgeräte, hier die Prozess- und Modulsteuerungen mit einer Benutzeroberfläche zu verbinden.

Infolge dieser zentralen Funktion der Schaltvorrichtung und der oben beschriebenen Funktionen der einzelnen Prüfeinheiten 9, 10 und der Ladeeinheit 11 sind durch die Verbindung zumindest einer der Benutzeroberflächen mit den verschiednen Steuerungen verschiedene Betriebszustände herstellbar, bei denen der halb- oder vollautomatische Betrieb der zugehörigen Prüfeinheiten 9, 10 in unterschiedlichsten Kombinationen möglich ist.

Die nachfolgende Tabelle zeigt in der zweiten und dritten Spalte die Betriebsarten der Prüfeinheiten 9 und 10 und Ladeeinheit 11, untergliedert in die möglichen Betriebszustände A bis E (erste Spalte). Die vierte und fünfte Spalte nennt die Steuerungen, die mit der ersten Benutzeroberfläche oder mit der zweiten Benutzeroberfläche verbunden sind. Dabei ist die erste Prozesssteuerung 3 als PS I, die zweite Prozesssteuerung als PS II und die Modulsteuerung als MS bezeichnet.

| | Komponente | | | | |
|---|---|---|---|---|---|
| | erste Prüfeinheit 9 (PE I) | zweite Prüfeinheit 10 (PE II) | Ladeeinheit 11 (LE) | erste Benutzeroberfläche (BO I) | zweite Benutzeroberfläche (BO II) |
| A | vollautomatisch | vollautomatisch | vollautomatisch | MS, PS I, PS II | passiv |
| B | vollautomatisch | vollautomatisch | vollautomatisch | passiv | MS, PS I, PS II |
| C | halbautomatisch | vollautomatisch | vollautomatisch | PS I | MS PS II |
| D | vollautomatisch | halbautomatisch | vollautomatisch | MS, PS I | PS II |
| E | halbautomatisch | halbautomatisch | passiv | PS I | PS II |

Danach verbindet im Betriebszustand A die Schaltvorrichtung 1 die erste Benutzeroberfläche mit der Modulsteuerung und darüber mit der Ladeeinheit 11 sowie mit beiden Prozesssteuerungen. Die zweite Benutzeroberfläche wird nicht benötigt und ist passiv. In diesem Betriebszustand arbeiten beide Prüfeinheiten vollautomatisch und werden durch die Ladeeinheit 11 vollautomatisch mit Testsubstraten 21 aus einem Testsubstratlager 17 beladen. Dabei fungiert die Modulsteuerung lediglich als Koordinator der Prozesssteuerungen und der Ladeeinheit 11, die eigentliche Steuerung der Prüfabläufe und der Antriebe 24 erfolgt über die jeweilige Prozesssteuerung.

Wie oben beschrieben kann alternativ auch die Modulsteuerung die Steuerung der Prüfabläufe vollständig übernehmen. Dies kommt z.B. dann in Betracht, wenn beide Prüfabläufe übereinstimmen. In diesem Fall würde auch die Modulsteuerung eine eigene Speichereinheit 32 aufweisen und die Verbindung von der Modulsteuerung kann anstelle zu den Prozesssteuerungen zu den Maschinensteuerungen hergestellt sein. Darüber hinaus kann alternativ auch auf die Verbindung der Modulsteuerung zur ersten Benutzeroberfläche entfallen, wenn die Prüfungen vollautomatisch ablaufen und/oder die Modulsteuerung eine minimale Benutzeroberfläche umfasst, über die z.B. lediglich Start und Ende der Prüfung eingebbar oder die Prüfung beobachtbar ist. Eine Umschaltung zwischen diesen verschiedenen Alternativen ist auch durch ergänzende Schaltvorrichtungen flexibel zu realisieren.

Betriebszustand A vergleichbar ist Betriebszustand B, bei dem durch entsprechende Schaltzustände der Schaltvorrichtung die zweite Benutzeroberfläche die Stelle der ersten Benutzeroberfläche einnimmt. Alle weiteren Verbindungen und damit verbundene Arbeitsweisen entsprechen Betriebszustand A.

Betriebszustände C und D sind durch den vollautomatischen Betrieb der einen und halbautomatischen Betrieb der anderen Prüfeinheit 9, 10 gekennzeichnet. Dazu sind mittels der Schaltvorrichtung einmal die zweite Prüfeinheit 10 mit der Ladeeinheit und mit der Modulsteuerung zu einem Modul zusammengeschaltet, dessen zweite Prüfeinheit 10 vollautomatisch arbeitet und entsprechend vollautomatisch über die Ladeeinheit 11 beladen wird. Dieses vollautomatische Modul wird durch die zweite Benutzeroberfläche bedient, wobei wie oben beschrieben alternativ bei entsprechender Ausstattung auch die Modulsteuerung die Funktionen der zweiten Benutzeroberfläche übernehmen kann.

In diesem Betriebszustand C bleibt die erste Prüfeinheit 9 zusammen mit der ersten Benutzeroberfläche dem halbautomatischen Betrieb vorbehalten, wobei auch diese beiden Komponenten mittels der Schaltvorrichtung miteinander verbunden und vom vollautomatischen Modul separiert sind. Beide Komponenten bilden ein halbautomatisches Modul.

Betriebszustand D stellt eine spiegelbildliche Entsprechung dar hinsichtlich Verwendung der ersten und zweiten Prüfeinheit 9, 10 sowie ersten und zweiten Benutzeroberfläche für den halbautomatischen und vollautomatischen Betrieb, d.h. für deren Verwendung im vollautomatischen und halbautomatischen Modul dar.

Im Betriebszustand E schließlich werden beide Prüfeinheiten 9, 10 halbautomatisch betrieben wobei jede Prüfeinheit 9, 10 mittels der Schaltvorrichtung mit einer Benutzeroberfläche verbunden ist. Die Modulsteuerung und die Ladeeinheit 11 sind hierbei passiv.

Da wie oben beschrieben in den verschiedenen Betriebszuständen sowohl für den halb- als auch für den vollautomatischen Betrieb die eine Benutzeroberfläche die Funktion der anderen ersetzen kann, ist es auch möglich, den Prober nur mit einer Benutzeroberfläche auszustatten oder den Ausstattungsgrad beider Oberflächen unterschiedlich auszugestalten und die höher ausgestattete Benutzeroberfläche dann zu verwenden, wenn die höheren Anforderungen an die Bedienung stehen. So reicht es z.B. aus, eine hochwertige Manipulationsvorrichtung nur in eine Benutzeroberfläche zu integrieren.

Im Ergebnis weist der beschriebene Prober eine sehr hohe Flexibilität hinsichtlich der verschiedensten Anwendungsfälle auf. Die vollautomatischen und halbautomatischen Module sind verschieden zusammenstellbar, so dass bei verschieden ausgestatteten Komponenten, z.B. Benutzeroberflächen, Prozess- und/oder Maschinensteuerungen und/oder Prüfeinheiten 9, 10 der Module die verschiedensten Prüfaufgaben in einem Prober ausführbar und miteinander kombinierbar sind. Selbstverständlich sind auch die Module einzeln zu betreiben.

### Bezugszeichenliste

- 3: erste Prozesssteuerung
- 5: erste Maschinensteuerung
- 9: erste Prüfeinheit
- 10: zweite Prüfeinheit
- 11: Ladeeinheit
- 15: Handlingsystem
- 16: Beladevorrichtung
- 17: Testsubstratlager, Wafer-Magazin
- 18: Chuck
- 19: Aufnahmefläche
- 20: Auflageplatte
- 21: Testsubstrat, Wafer
- 22: Ausrichtstation
- 23: Positionierungseinheit
- 24: Antrieb
- 25: Sondenhalterung
- 26: Sondenanordnung, Sonden
- 27: Probecard
- 28: zentrale Öffnungen
- 29: Gehäuse
- 30: Beobachtungseinheit
- 31: Steuerung der Beobachtungseinheit
- 32: Speichereinheit

## Patentansprüche

1. Prober zum Prüfen und Testen von elektronischen Halbleiterbauelementen, nachfolgend als Testsubstrat (21) bezeichnet, folgende Komponenten umfassend:
- zumindest eine erste Prüfeinheit (9) und eine zweite Prüfeinheit (10),
- wobei jede Prüfeinheit (9, 10) einen Chuck (18) zur Aufnahme und Halterung eines Testsubstrats (21) auf einer Aufnahmefläche (19) des Chucks (18), eine Sondenhalterung (25) mit einer Sondenanordnung (26) mit mehreren Sonden (26) zur elektrischen Kontaktierung eines Testsubstrats (21) und eine Positionierungseinheit (23) mit motorisierten Antrieben (24) zur Positionierung von Chuck (18) und Sondenanordnung (26) relativ zueinander umfasst,
- wobei zumindest eine Prüfeinheit (9, 10) eine Beladevorrichtung (16) zum manuellen Beladen des Chucks (18) mit einem Testsubstrat (21) umfasst,
- zumindest eine erste Maschinensteuerung (5) zur Steuerung der motorisierten Antriebe (24) der ersten Prüfeinheit (9) und eine zweite Maschinensteuerung zur Steuerung der motorisierten Antriebe (24) der zweiten Prüfeinheit (10),
- zumindest eine erste Prozesssteuerung (3) zur Steuerung des Prüfprozesses der ersten Prüfeinheit (9) und eine zweite Prozesssteuerung zur Steuerung des Prüfprozesses der zweiten Prüfeinheit (10), wobei zumindest eine Prozesssteuerung eine Speichereinheit (32) umfasst zur Speicherung von Daten des Testsubstrats (21) und von Prüfabläufen,
- eine Ladeeinheit (11), die ein Handlingsystem (15) umfasst zur automatisierten Übernahme und Übergabe eines Testsubstrats (21) zwischen einem Testsubstratlager (17) und sowohl der einen als auch der anderen Prüfeinheit (9, 10),
- eine Modulsteuerung (2) zur Steuerung der ersten und zweiten Prozesssteuerung und/oder der ersten und zweiten Maschinensteuerung und der Ladeeinheit (11),
- eine Benutzeroberfläche mit einer Anzeige- und einer Eingabevorrichtung und
- eine Schaltvorrichtung zur wahlweisen Herstellung einer elektrischen Verbindung von der Benutzeroberfläche zu zumindest einer der folgenden Steuerungen: erste Prozesssteuerung (3) oder zweite Prozesssteuerung oder Modulsteuerung.

2. Prober nach Anspruch 1, wobei zumindest einer der Chucks (18) der Prüfeinheiten (9, 10) eine Auflageplatte (20) umfasst, deren eine Oberfläche die Aufnahmefläche (19) bildet, und die Beladevorrichtung (16) der die Auflageplatte (20) aufweisenden Prüfeinheit (9, 10) und/oder die Ladeeinheit (11) Mittel umfasst zur Entnahme der Auflageplatte (20) aus der Prüfeinheit (9, 10).

3. Prober nach einem der vorstehenden Ansprüche, wobei die Benutzeroberfläche eine Manipulationsvorrichtung zur Bedienung der motorisierten Antriebe (24) der ersten und/oder der zweiten Prüfeinheit (9, 10) umfasst.

4. Prober nach einem der vorstehenden Ansprüche, wobei zumindest eine Prüfeinheit (9, 10) mit EMI-Abschirmung ausgerüstete ist zur Durchführung von Low-Current- und Low-Voltage-Messungen.

5. Prober nach einem der vorstehenden Ansprüche, wobei eine weitere Benutzeroberfläche angeordnet und eine der Benutzeroberflächen als erste Benutzeroberfläche der ersten Prüfeinheit (9) und die andere als zweite Benutzeroberfläche der zweiten Prüfeinheit (10) zugeordnet ist.

6. Prober nach einem der vorstehenden Ansprüche, wobei die Modulsteuerung eine Modul-Benutzeroberfläche mit einer Anzeige- und einer Eingabevorrichtung umfasst.

7. Verfahren zum Betrieb eines Probers nach einem der vorstehenden Ansprüche, wobei mittels der Schaltvorrichtung wahlweise
- die Modulsteuerung mit einer oder mit beiden Prüfeinheiten (9, 10) verbunden wird zum vollautomatischen Betrieb der jeweils mit der Modulsteuerung verbundenen Prüfeinheit (9, 10) oder
- eine Benutzeroberfläche des Probers mit einer oder mit beiden Prüfeinheiten (9, 10) verbunden wird zum halbautomatischen Betrieb der jeweils mit der Benutzeroberfläche verbundenen Prüfeinheit (9, 10),
- wobei beim vollautomatischen Betrieb die Beladung des Chucks (18) der mit der Modulsteuerung verbundenen Prüfeinheit (9, 10) mit einem Testsubstrat (21), die Positionierung von Testsubstrat (21) und Sonden (26) relativ zueinander und die Kontaktierung sowie Messungen automatisiert erfolgen und
- wobei beim halbautomatischen Betrieb die Beladung des Chucks (18) der mit der Benutzeroberfläche verbundenen Prüfeinheit (9, 10) mit einem Testsubstrat (21) manuell erfolgt.

8. Verfahren zum Betrieb eines Probers nach Anspruch 7, wobei beim vollautomatischen Betrieb die Modulsteuerung die Prüfeinheit (9, 10) direkt steuert, indem die Prüfabläufe in einer Speichereinheit (32) der Modulsteuerung gespeichert sind, oder durch Aktivierung der Prozesssteuerung der mit der Modulsteuerung verbundenen Prüfeinheit (9, 10), wobei hierbei die Prüfabläufe in einer Speichereinheit (32) der Prozesssteuerung gespeichert sind.

9. Verfahren zum Betrieb eines Probers nach Anspruch 7 oder 8, wobei beim halbautomatischen Betrieb die Positionierung des auf dem Chuck (18) aufliegenden Testsubstrats (21) und der Sonden (26) relativ zueinander zumindest teilweise über Eingaben an der Benutzeroberfläche zur Bedienung der motorisierten Antriebe (24) erfolgt.

10. Verfahren zum Betrieb eines Probers nach einem der Ansprüche 7 bis 9, wobei beim halbautomatischen Betrieb zumindest ein Einzelschritt zur Positionierung des auf dem Chuck (18) aufliegenden Testsubstrats (21) und der Sonden (26) relativ zueinander automatisiert erfolgt.

## Claims

1. Prober for verifying and testing electronic semiconductor devices, subsequently referred to as test substrate (21), comprising the following components:
- at least a first verification unit (9) and a second verification unit (10),
- wherein each verification unit (9, 10) comprises a chuck (18) for receiving and holding a test substrate (21) on a receiving surface (19) of the chuck (18), a probe mount (25) having a probe arrangement (26) containing multiple probes (26) for making electrical contact with a test substrate (21), and a positioning unit (23) having motorized drives (24) for positioning the chuck (18) and the probe arrangement (26) relative to one another,
- wherein at least one verification unit (9, 10) comprises a loading apparatus (16) for manually loading the chuck (18) with a test substrate (21) ,
- at least a first machine controller (5) for controlling the motorized drives (24) of the first verification unit (9) and a second machine controller for controlling the motorized drives (24) of the second verification unit (10),
- at least a first process controller (3) for controlling the verification process of the first verification unit (9) and a second process controller for controlling the verification process of the second verification unit (10), wherein at least one process controller comprises a memory unit (32) for storing data of the test substrate (21) and verification sequences,
- a charging unit (11) that comprises a handling system (15) for accepting and transferring a test substrate (21) between a test substrate store (17) and either one or the other verification unit (9, 10) in an automated manner,
- a module controller (2) for controlling the first and second process controllers and/or the first and second machine controllers and the charging unit (11),
- a user interface having a display apparatus and an input apparatus, and
- a switching apparatus for selectively making an electrical connection from the user interface to at least one of the following controllers: first process controller (3) or second process controller or module controller.

2. Prober according to Claim 1, wherein at least one of the chucks (18) of the verification units (9, 10) comprises a support plate (20), one surface of which forms the receiving surface (19), and the loading apparatus (16) of the verification unit (9, 10) that has the support plate (20) and/or the charging unit (11) comprise(s) means for removing the support plate (20) from the verification unit (9, 10).

3. Prober according to either of the preceding claims, wherein the user interface comprises a manipulation apparatus for operating the motorized drives (24) of the first and/or the second verification unit (9, 10).

4. Prober according to one of the preceding claims, wherein at least one verification unit (9, 10) is equipped with EMI screening for the purpose of performing low-current and low-voltage measurements.

5. Prober according to one of the preceding claims, wherein a further user interface is arranged and one of the user interfaces is assigned to the first verification unit (9) as first user interface and the other is assigned to the second verification unit (10) as second user interface.

6. Prober according to one of the preceding claims, wherein the module controller comprises a module user interface having a display apparatus and an input apparatus.

7. Method for operating a prober according to one of the preceding claims, wherein the switching apparatus is used to selectively
- connect the module controller to one or to both verification unit(s) (9, 10) for the purpose of fully automatic operation of the respective verification unit (9, 10) connected to the module controller or
- connect a user interface of the prober to one or to both verification unit(s) (9, 10) for the purpose of semiautomatic operation of the respective verification unit (9, 10) connected to the user interface,
- wherein fully automatic operation involves the loading of the chuck (18) of the verification unit (9, 10) connected to the module controller with a test substrate (21), the positioning of the test substrate (21) and the probes (26) relative to one another and the contact-making and measurements being effected in automated fashion, and
- wherein semiautomatic operation involves the loading of the chuck (18) of the verification unit (9, 10) connected to the user interface with a test substrate (21) being effected manually.

8. Method for operating a prober according to Claim 7, wherein fully automatic operation involves the module controller controlling the verification unit (9, 10) directly by virtue of the verification sequences being stored in a memory unit (32) of the module controller, or by activating the process controller of the verification unit (9, 10) connected to the module controller, this involving the process sequences being stored in a memory unit (32) of the process controller.

9. Method for operating a prober according to Claim 7 or 8, wherein semiautomatic operation involves the positioning of the test substrate (21) supported by the chuck (18) and of the probes (26) relative to one another being effected at least in part by means of inputs on the user interface for the purpose of operating the motorized drives (24).

10. Method for operating a prober according to one of Claims 7 to 9, wherein semiautomatic operation involves at least one single step for positioning the test substrate (21) supported by the chuck (18) and the probes (26) relative to one another being effected in automated fashion.

## Revendications

1. Dispositif de test microélectronique destiné à contrôler et tester des composants électroniques à semi-conducteurs, désignés ci-après par substrat de test (21), ledit dispositif de test microélectronique comprenant les composants suivants :
- au moins une première unité de contrôle (9) et une deuxième unité de contrôle (10),
- chaque unité de contrôle (9, 10) comprenant un mandrin (18) destiné à recevoir et maintenir un substrat de test (21) sur une surface de réception (19) du mandrin (18), un porte-sondes (25) pourvu d'un ensemble de sondes (26) comportant plusieurs sondes (26) destinées à venir en contact électrique avec un substrat de test (21) et une unité de positionnement (23) pourvue d'entraînements motorisés (24) et destinée à positionner le mandrin (18) et l'ensemble de sondes (26) l'un par rapport à l'autre,
- au moins une unité de contrôle (9, 10) comprenant un dispositif de chargement (16) destiné à charger manuellement le mandrin (18) avec un substrat de test (21) ,
- au moins une première commande de machine (5) destinée à commander les entraînements motorisés (24) de la première unité de contrôle (9) et une deuxième commande de machine destinée à commander les entraînements motorisés (24) de la deuxième unité de contrôle (10),
- au moins une première commande de processus (3) destinée à commander le processus de contrôle de la première unité de contrôle (9) et une deuxième commande de processus destinée à commande le processus de contrôle de la deuxième unité de contrôle (10), au moins une commande de processus comprenant une unité de mémorisation (32) destinée à mémoriser des données du substrat de test (21) et des opérations de contrôle,
- une unité de chargement (11) qui comprend un système de manipulation (15) destiné à prendre en charge de manière automatisée et à transférer un substrat de test (21) entre un magasin de substrat de test (17) et aussi bien l'une que l'autre unité de contrôle (9, 10) ,
- une commande de module (2) destinée à commander la première et la deuxième commande de processus et/ou la première et la deuxième commande de machine et l'unité de chargement (11),
- une interface utilisateur pourvue d'un dispositif d'affichage et d'un dispositif d'entrée et
- un dispositif de commutation destiné à établir au choix une liaison électrique depuis l'interface utilisateur vers l'une au moins des commandes suivantes : la première commande de processus (3) ou la deuxième commande de processus ou la commande de module.

2. Dispositif de test microélectronique selon la revendication 1, l'un au moins des mandrins (18) des unités de contrôle (9, 10) comprenant une plaque de support (20), dont une surface forme la surface de réception (19), et le dispositif de chargement (16) de l'unité de contrôle (9, 10), qui comporte la plaque de support (20), et/ou l'unité de chargement (11) comprenant des moyens destinés à retirer la plaque de support (20) de l'unité de contrôle (9, 10).

3. Dispositif de test microélectronique selon l'une des revendications précédentes, l'interface utilisateur comprenant un dispositif de manipulation destiné à faire fonctionner les entraînements motorisés (24) de la première et/ou de la deuxième unité de contrôle (9, 10) .

4. Dispositif de test microélectronique selon l'une des revendications précédentes, au moins une unité de contrôle (9, 10) étant équipée d'un blindage EMI pour effectuer des mesures à faible courant et à basse tension.

5. Dispositif de test microélectronique selon l'une des revendications précédentes, une autre interface utilisateur étant disposée et l'une des interfaces utilisateur étant associée en tant que première interface utilisateur à la première unité de contrôle (9) et l'autre étant associée en tant que deuxième interface utilisateur à. la deuxième unité de contrôle (10) .

6. Dispositif de test microélectronique selon l'une des revendications précédentes, la commande de module comprenant une interface utilisateur de module pourvue d'un dispositif d'affichage et d'un dispositif d'entrée.

7. Procédé de fonctionnement d'un dispositif de test microélectronique selon l'une des revendications précédentes, le dispositif de commutation permettant au choix
- de relier la commande de module à l'une des unités de contrôle (9, 10) ou aux deux pour faire fonctionner de manière entièrement automatique l'unité de contrôle (9, 10) reliée à la commande de module ou
- de relier une interface utilisateur du dispositif de test microélectronique à l'une des unités de contrôle (9, 10) ou aux deux pour faire fonctionner de manière semi-automatique l'unité de contrôle (9, 10) reliée à l'interface utilisateur,
- en fonctionnement entièrement automatique, le chargement du mandrin (18) de l'unité de contrôle (9, 10) reliée à la commande de module et pourvue d'un substrat de test (21), le positionnement du substrat de test (21) et des sondes (26) les uns par rapport aux autres et la mise en contact et les mesures étant effectués de manière automatisée et
- en fonctionnement semi-automatique, le chargement du mandrin (18) de l'unité de contrôle (9, 10) reliée à l'interface utilisateur et pourvue d'un substrat de test (21) étant effectué manuellement.

8. Procédé de fonctionnement d'un dispositif de test microélectronique selon la revendication 7, en fonctionnement entièrement automatique, la commande de module commandant directement l'unité de contrôle (9, 10) en mémorisant les opération de contrôle dans une unité de mémorisation (32) de la commande de module, ou en activant la commande de processus de l'unité de contrôle (9, 10) reliée à la commande de module, les opérations de contrôle étant mémorisées dans une unité de mémorisation (32) de la commande de processus.

9. Procédé de fonctionnement d'un dispositif de test microélectronique selon la revendication 7 ou 8, en fonctionnement semi-automatique, le positionnement du substrat de test (21), supporté par le mandrin (18), et des sondes (26) les uns par rapport aux autres étant effectué au moins partiellement via des entrées au niveau de l'interface utilisateur pour faire fonctionner les entraînements motorisés (24).

10. Procédé de fonctionnement d'un dispositif de test microélectronique selon l'une des revendications 7 à 9, en fonctionnement semi-automatique, au moins une étape indépendante de positionnement du substrat de test (21), supporté par le mandrin (18), et des sondes (26) les uns par rapport aux autres étant effectué de manière automatisée.
